# EUROPEAN PATENT SPECIFICATION

(11) **EP 1 273 047 B1**
(45) Date of publication and mention of the grant of the patent: **14.03.2007**
(21) Application number: 01927893.6
(22) Date of filing: 09.04.2001
(51) Int. Cl.: H01L 31/02, H01L 31/107, H01L 27/146

(54) **ULTRASENSITIVE PHOTODETECTOR WITH INTEGRATED PINHOLE FOR CONFOCAL MICROSCOPES AND METHOD TO DETECT OPTICAL SIGNAL**
ULTRAEMPFINDLICHER PHOTODETEKTOR MIT INTEGRIERTEM PINHOLE FÜR KONFOKALE MIKROSKOPE UND VERFAHREN ZUR DETEKTION OPTISCHES SIGNAL
PHOTODETECTEUR ULTRASENSIBLE A STENOPE INTEGRE, POUR MICROSCOPES CONFOCAUX ET PROCÉDÉ DE DÉTECTION D'UN SIGNAL OPTIQUE

(30) Priority: 10.04.2000 IT MI20000765
(43) Date of publication of application: 08.01.2003
(73) Proprietor: Politecnico Di Milano, 20133 Milano (IT); CARL ZEISS JENA GmbH, 07745 JENA (DE)
(72) Inventor: COVA, Sergio, I-20133 Milano (IT); ZAPPA, Franco, I-20099 Sesto San Giovanni (IT); GHIONI, Massimo, I-20052 Monza (IT); GRUB, Robert, 73540 Heubach (DE); DERNDINGER, Eberhard, 73430 Aalen (DE); HARTMANN, Thomas, 82449 Uffing A. Staffelsee (DE)
(74) Representative: Mittler, Enrico
(86) International application number: PCT/EP2001/004008
(87) International publication number: WO 2001/078153

(56) References cited:
- US-A- 4 127 932
- US-A- 5 831 322
- LACAITA A ET AL: "Germanium quad-cell for single photon detection in the near infrared" PHOTODETECTORS AND POWER METERS II, SAN DIEGO, CA, USA, 11-12 JULY 1995, vol. 2550, pages 274-283, XP002179902 Proceedings of the SPIE - The International Society for Optical Engineering, 1995, SPIE-Int. Soc. Opt. Eng, USA ISSN: 0277-786X
- PATENT ABSTRACTS OF JAPAN vol. 1998, no. 14, 31 December 1998 (1998-12-31) & JP 10 233525 A (HAMAMATSU PHOTONICS KK), 2 September 1998 (1998-09-02)
- PATENT ABSTRACTS OF JAPAN vol. 1995, no. 06, 31 July 1995 (1995-07-31) & JP 07 074390 A (NIKON CORP), 17 March 1995 (1995-03-17)
- ZAPPA F ET AL: "Integrated array of avalanche photodiodes for single-photon counting" ESSDERC '97. PROCEEDINGS OF THE 27TH EUROPEAN SOLID-STATE DEVICE RESEARCH CONFERENCE, 27TH EUROPEAN SOLID-STATE DEVICE RESEARCH CONFERENCE (ESSDERC '97), STUTTGART, GERMANY, 22-24 SEPT. 1997, pages 600-603, XP002179903 1997, Paris, France, Editions Frontieres, France ISBN: 2-86332-221-4
- ZANCHI A ET AL: "A PROBE DETECTOR FOR DEFECTIVITY ASSESSMENT IN P-N JUNCTIONS" IEEE TRANSACTIONS ON ELECTRON DEVICES, IEEE INC. NEW YORK, US, vol. 47, no. 3, March 2000 (2000-03), pages 609-615, XP000947942 ISSN: 0018-9383

## Description

The present invention refers to a photodetector device with high sensitivity and equipped with an adjustable micrometric diaphragm integrated in the photodetector device itself. More specifically it is a detector device suitable for use in confocal microscopes.

Photodetector devices that enable optical signals to be measured are already known. There are cases in their application in which the information of interest is brought only by the light signal incident on a small well-defined area. In such cases a photodetector is required to generate an output signal only in correspondence with the arrival of the photons on that small area.

In particular in confocal microscopes a light detector apparatus is used which functions in the above mentioned manner and which in addition has a very high detection sensitivity, suitable for working with ultra-weak illumination intensity, in various cases even managing to detect single photons. To reach these high sensitivities it is necessary to use photodetectors, which also with ultra-weak illumination intensity supply electrical signals of level higher than the noise of the electronic circuits that process the signals themselves, so that the sensitivity is not limited by the noise of the circuits. Photodetector devices available with said characteristics are photomultiplier tubes (PMT), avalanche photodiodes that work in a similar way to an amplifier (Avalanche PhotoDiodes APD), avalanche photodiodes that work in the Geiger mode (Single Photon Avalanche Diodes SPAD). The selection of the light that arrives at the photodetector device is obtained with a mechanical micrometric diaphragm with accurately defined diameter and position of the opening, placed in front of the photodetector itself.

In various cases it is also required that the area selected be adjustable to meet the various needs in the various phases of a same measurement or in a sequence of measurements made in different conditions. Typical cases in a confocal microscope are those in which it is necessary to detect the light signal coming from very small samples (also single molecules diluted in a fluid), which is difficult to do using a very small diameter diaphragm. In these cases a preliminary observation of the samples is necessary using a micrometric diaphragm with a larger diameter to collect the light from a greater observed volume and, when the object being looked for has been identified, pass on to using a narrower micrometric diaphragm to obtain a more precise measurement, limiting the observation to a smaller and better defined volume. Nevertheless this requires the use of an adjustable mechanical micrometric diaphragm, which implies an increase in size, complexity and cost for the detection apparatus, an increase that turns out to be particularly remarkable if the apparatus is made so that it can be controlled by the electronic control system of the microscope.

It is beneficial to avoid the use of electromagnetic actuators and mobile mechanical parts, using instead a photodetector that has a sensitive area whose dimensions can be controlled only by electronic means and that has the high sensitivity required.

A solution to this problem can be found in the use of a photodetector equipped with a sensitive area divided into small parts (pixel), that is, an array detector or an image detector. Nevertheless the array detectors and the image detectors at present available have characteristics, which are not very suitable for the solution of the above-mentioned problem.

Among the photomultiplier tubes (PMT) in industrial production, types with the anode subdivided into small areas are available, but these areas are not small enough and are separated by sizeable dead spaces, which significantly reduce the detection efficiency. In addition, these PMT have a high number of separate electrical outputs (one per pixel), which increase the complexity, overall dimension and cost of the electronic circuits for processing the signals.

Other types of PMT permit a detection of the optical impulses sensitive to the position of incidence within a detection area that is continuous, that is, without dead spaces. Nevertheless, they are costly and cumbersome and require the use of complex electronic circuits for extracting the information concerning the position of incidence of the optical signal inside the sensitive area. They can work at a high sensitivity level, even at single-photon detection level, but the maximum allowable counting rate of photons detected on the whole area is less than that reached by an ordinary PMT. This limitation reduces considerably the dynamic range of the measurement.

The APD arrays, nowadays available also from industrial production, show drawbacks similar to those of the above mentioned PMT with segmented anode, to which it must be added that of having a multiplication gain that is not high (values from a few tens to a few hundreds), which is not uniform for the various pixels and which varies as the temperature varies.

The SPAD arrays, which in contrast to the above mentioned detectors are not as yet available commercially and are a research objective, present the difficult problem of the optical cross-talk between pixels. This cross-talk is due to the optical emission by the avalanche current charge carriers in a pixel, which generates false photon detection signals in the adj acent pixels. In order to eliminate it, an efficient optical insulation of the pixels must be provided, but this presents considerable technological manufacturing difficulties and anyway causes an increase of the dead spaces between the pixels and of the cost of production of the SPAD arrays.

Document US 5831322 describes an avalanche photodiode array with large active area, whilst document US 4127932 discloses a method of fabricating silicon-based photodiodes.

From the Patent USA No. 5,900,949 it appears that also CCD image detectors (Charge coupled devices) have been used for the said purpose. These detectors are available from industrial production and have various interesting characteristics (good quantum detection efficiency, flexibility of use, etc.). However they have no internal gain and therefore their sensitivity is definitely lower and it is not possible to detect single photons with them.

JP-A-07221341 discloses a silicon avalanche photodiode according to the preamble of claim 1.

In view of the state of the technique described, the object of the present invention is to construct a photodetector device as recited in claim 1 with integrated micrometric diaphragm suitable for use in confocal microscopes, and which has a simpler structure and is easier to use than existing devices and which is capable of measuring ultra-weak light intensities.

Another object is to provide an improved method for detecting an optical signal as recited in claim 7.

In accordance with the present invention, said object is reached by means of a photodetector device as defined in claim 1 and a method as defined in claim 7.

Thanks to the present invention a high sensitivity photodetector device can be constructed which presents a sensitive area whose dimensions can be controlled electronically without coming across the problems met with the present types of photodetectors, in particular avoiding the use of micrometric diaphragms external to the detector.

The characteristics and advantages of the present invention will appear evident from the following detailed description of its embodiments thereof, illustrated as non-limiting examples in the enclosed drawings, in which:
Figures 1 and 2 show perspective views of cross-sections of avalanche diodes according to the known technique and used as APD or SPAD photodetectors;
Figure 3 shows a perspective view in of the cross-section of a photodetector device according to a first embodiment of the present invention;
Figure 4 shows a perspective view of the cross-section of a photodetector device according to a second embodiment of the present invention;
Figure 5 shows a perspective view of the cross-section of the photodetector device according to a variant of the first embodiment of the present invention;
Figure 6 shows schematically various possible geometries of the active areas of a photodetector device according to the present invention.

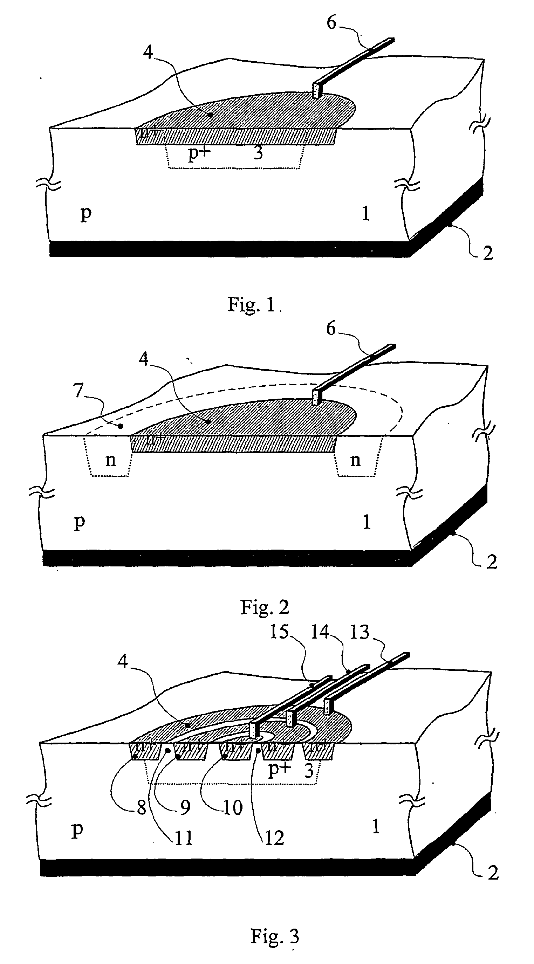

In Figures 1 and 2 perspective views are shown of the cross-sections of avalanche diodes according to the known technique. A substrate 1 of P type semiconductor is connected in the lower part to a metallic electrode 2. A region 4 of N+ type semiconductor provided with an electrode 6 is placed on the upper part of the substrate 1. At the centre of Figure 1 there is a P+ type region 3 not as wide as region 4 so that the electric field intensity on the edge of region 4 is less high and the breakdown on the edge itself is avoided. In Figure 2 the same result is obtained with an N type region 7 that surrounds region 4 and has a lower density of dopant than said region 4, so that it constitutes an electrical guard ring. Electrode 6 acts as a cathode and electrode 2 as an anode. Alternatively it is possible to interchange the P and N polarities of said regions of the semiconductor and to interchange the functions of cathode and anode of the said electrodes.

In Figure 3 a perspective view of the cross-section of an avalanche diode is shown according to a first embodiment of the invention. Differently from the avalanche diodes of Figures 1 and 2 region 4 is subdivided into small N+ type semiconductor sub-regions 8, 9, 10 in the form of concentric rings separated from each other by means of portions 11, 12 of the P+ type semiconductor region 3. Sub-regions 8, 9, 10 are contacted, each of them, by means of respective 13, 14, 15 electrodes separated from each other so that it is possible to control independently the bias voltage applied between each electrode of the sub-regions 8, 9, 10 and the electrode 2.

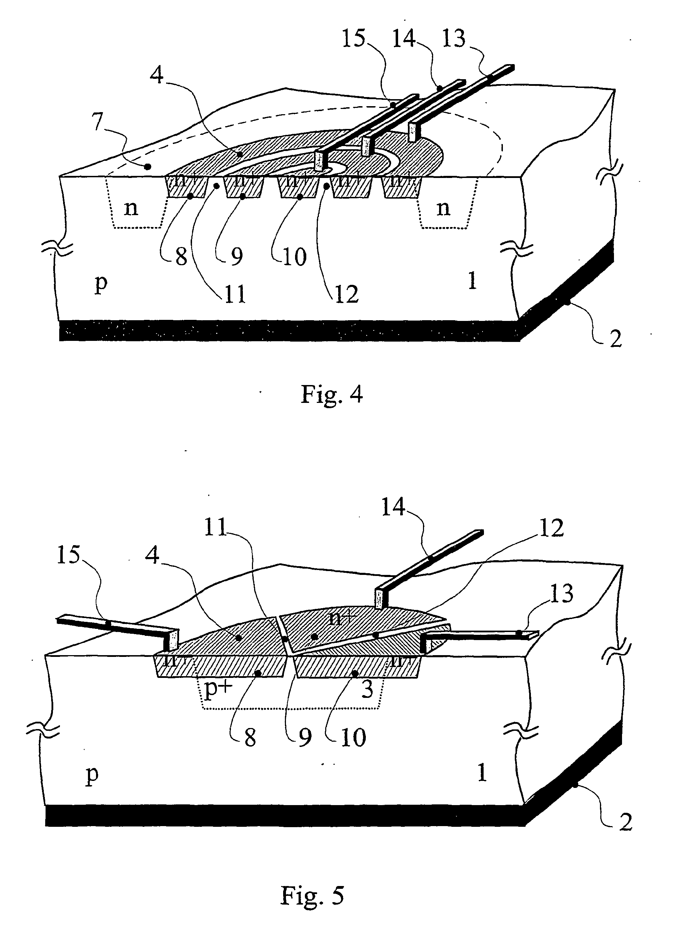

Figure 4 shows a perspective view of the cross-section of an avalanche diode according to a second embodiment of the invention, which is different from that of Figure 3 for the fact that the sub-regions 8, 9, 10 ofN+ type semiconductor in the form of concentric rings are separated from each other by means of portions 11, 12 of the P type substrate 1 and in addition an N type region 7 is present which surrounds region 4 and has a lower density of dopant than said region 4, so that it constitutes a guard ring.

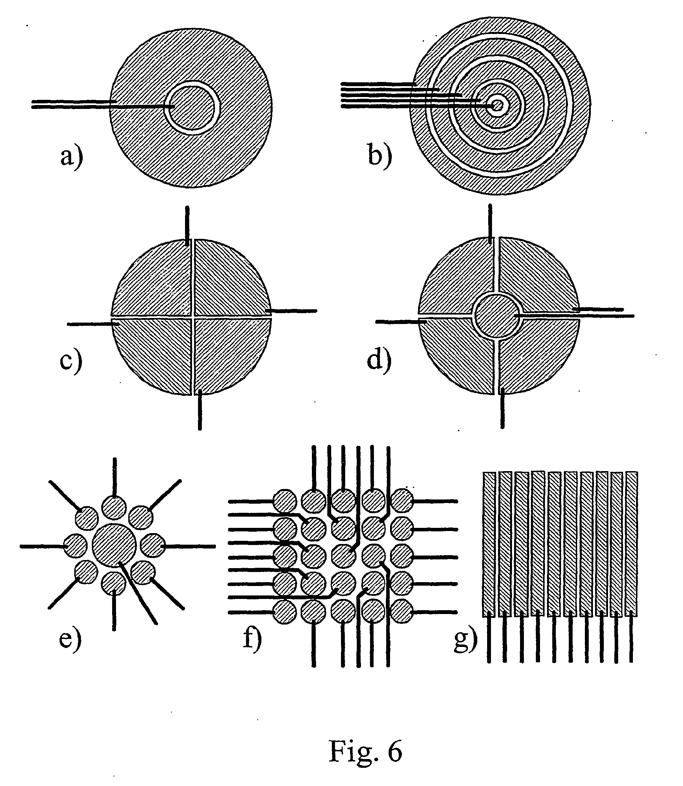

Several variants of the avalanche diodes shown in Figure 3, mainly concerning the geometric form of the N+ type semiconductor sub-regions, are represented in Figures 5 and 6. In Figure 5 the N+ type semiconductor sub-regions have a sector shape while Figure 6 shows the various forms that the same sub-regions can take according to the possible uses of the avalanche diode: with two concentric rings (a), with more concentric rings (b), with four equal sectors (c), with different sectors (d), with circles (e), with circles of the same size (f), with stripes (g). The above-mentioned variations of geometric forms of the N+ type semiconductor sub-regions can also be made for the structure illustrated in Figure 4.

The structure of the avalanche diode in accordance with the invention finds application both in the case of APD devices and in the case of SPAD devices.

The APD devices are avalanche diodes which have internal linear amplification with internal gain of a different value according to the value of the bias voltage. In fact, if the inverse bias voltage is kept well below the avalanche breakdown voltage of the diode there is no multiplication and a single photon generates only one electron-hole pair, which is simply collected; therefore the diode works without amplifying the photogenerated current, that is with unitary gain of current. When instead the bias voltage is brought close to the breakdown voltage, but still remains lower than it, the avalanche multiplication phenomenon is obtained and therefore a single photon triggers a chain generation of electron-hole pairs which amplifies the current due to the primary photogenerated carriers, producing a much greater current at the output of the diode. The diode thus works with a gain of current much higher than the unit, which gradually increases as the bias voltage comes closer to breakdown voltage, but still remains lower than it.

SPAD devices, which represent the preferred use of the avalanche diode according to the invention, have a different operation mode according to the value of the bias voltage. In fact if the bias voltage stays well below the value of the avalanche breakdown voltage there is no multiplication and a single photon generates only one electron-hole pair, thus producing a microscopic current pulse. Said pulse cannot be detected by an electronic circuit because it is much smaller than the noise of the circuit itself. When the bias voltage is higher than the avalanche breakdown voltage the SPAD diode operates in Geiger mode and a single photon absorbed by the diode generates an electron-hole pair, which triggers a phenomenon of self-sustaining avalanche multiplication, thus producing a pulse of current of considerable level, well above that of the noise in the electronic circuits. Said pulse can be easily detected, processed and used in circuits, such as pulse comparator circuits and pulse counter circuits.

The structure of the avalanche diode according to the invention permits a new method for the detection of the optic signal.

The light signal impinges on the active area of the diode which in the case of the devices of Figures 3 and 4 is constituted by the array of the N+ type semiconductor sub-regions 8, 9, 10 separate from each other.

Among these N+ type semiconductor regions, a bias voltage that is low enough to prevent the phenomenon of avalanche multiplication from occurring is applied to those sub-regions that must be kept shielded from the action of the optical signal, called inhibited areas. In the case of the APD device said voltage must be sufficiently lower than the breakdown voltage so as to prevent the amplification of the signal. In the case of SPAD devices said voltage must be lower than the breakdown voltage.

A bias voltage is applied to those N+ type semiconductor sub-regions that instead must be sensitive to the incident signal, called enabled areas, which is high enough to guarantee that the phenomenon of avalanche multiplication occurs with sufficiently high intensity to permit the detection and processing of the signal by a circuit (not visible) connected to the output electrode 2. More precisely, in the case of APD devices said voltage, must be lower than the breakdown voltage and close enough to the breakdown voltage to guarantee a high current gain; in the case of SPAD devices said voltage must be higher than the breakdown voltage and sufficient to ensure the operation of the diode in Geiger mode.

A characteristic of this device that differentiates it from the APD or SPAD array devices is that in all the working configurations, that is, whatever is the choice of the voltages applied and therefore whatever is the selection of the enabled areas, the output signal of the photodetector device is supplied by the same single electrode. The preferred choice for the output electrode is that of the electrode 2. An alternative choice is an electrode connected to an N+ zone that in the working conditions of the device is always enabled, since it is comprised in the minimum enabled area used. As a non-limiting example of this second choice, in the devices of Figures 3 and 4 the electrode 15 connected to the zone 10 situated at the centre of the active area may be taken as output electrode.

## Claims

1. Photodetector device comprising a semiconductor substrate (1) of a first type of conductivity connected to a first electrode (2) and an active region (4) of a second type of conductivity formed on a surface of the substrate for receiving an optical signal to be detected, said active region (4) being made up of a plurality of semiconductor sub-regions (8, 9, 10) which are electrically insulated from each other by portions (11, 12) of the substrate (1) and are independently connected to respective second electrodes (13, 14, 15), **characterized in that** said second electrodes (13, 14, 15) are independently controlled by selectable bias voltages able to produce avalanche multiplication of charge carriers under the corresponding semiconductor sub-regions (8, 9, 10) and a resulting electrical output signal indicative of the optical signal to be detected.

2. Device according to claim 1, **characterised in that** it provides a further semiconductor region (3) of the first type of conductivity with high dopant density, provided under said active region (4).

3. Device according to claim 2, **characterized in that** the width of said further semiconductor region (3) is smaller than the width of said active region (4).

4. Device according to claim 1, **characterized in that** a ring-shaped semiconductor region (7) of the second type of conductivity with a lower dopant density than that of said semiconductor sub-regions (8, 9, 10) of said active region (4) is provided around said active region (4).

5. Device according to claim 1, **characterized in that** said semiconductor sub-regions (8, 9, 10) of said active region (4) have the shape of concentric rings.

6. Device according to claim 1, **characterized in that** said semiconductor sub-regions (8, 9, 10) of said active region (4) have the shape of circumference sectors.

7. Method of detection of an optical signal comprising:
- the incidence of said optical signal on an active region (4) of a semiconductor photodetector device, said active region (4) being formed on a surface of a semiconductor substrate (1) of a first type of conductivity connected to a first electrode (2) and being made up of a plurality of semiconductor sub-regions (8, 9, 10) of a second type of conductivity electrically insulated from each other by portions (11, 12) of the substrate (1) and independently connected to respective second electrodes (13, 14, 15),
- the electronic selection of said semiconductor sub-regions (8, 9, 10) by connection of said second electrodes (13, 14, 15) to respective bias voltages able to produce avalanche multiplication of charge carriers under the corresponding semiconductor sub-regions (8, 9, 10), and
- the detection of the electrical output signal generated by the avalanche multiplication of the charge carriers.

8. Method according to claim 7, **characterized in that** some of said semiconductor sub-regions (8, 9, 10) of said active region (4), called enabled areas, are connected to a bias voltage lower than the breakdown voltage of said photodetector device but close enough to it to have avalanche multiplication of the charge carriers such to ensure a current gain significantly greater than the unit.

9. Method according to claim 7, **characterized in that** several of said semiconductor sub-regions (8, 9, 10) of said active region (4), called enabled areas, are connected to a bias voltage higher than the breakdown voltage of said photodetector device.

10. Method according to claim 8 or 9, **characterized in that** the remaining semiconductor sub-regions (8, 9, 10) of said active region (4), called inhibited areas, are connected to a sufficiently low voltage to prevent said avalanche multiplication.

11. Method according to claims 7, 8, 9, 10 **characterized in that** the electrical output signal is supplied by an output electrode which is one of said first and second electrodes (2; 13, 14, 15) independently of the choice of the voltages bias applied to the several semiconductor sub-regions (8, 9, 10).

12. Method according to claim 11, **characterized in that** the output electrode that supplies the electrical signal is the first electrode (2).

13. Method according to claim 11, **characterized in that** the output electrode that supplies the electrical signal is one of the second electrodes (13, 14, 15), that is connected to one of the semiconductor sub-regions (8, 9, 10) which in the working conditions of the device is always an enabled area.

## Patentansprüche

1. Photodetektorvorrichtung mit einem Halbleitersubstrat (1) eines ersten Leitfähigkeitstyps, das mit einer ersten Elektrode (2) verbunden ist, und einem aktiven Bereich (4) eines zweiten Leitfähigkeitstyps, der auf einer Oberfläche des Substrats ausgebildet ist, zum Empfangen eines zu erfassenden optischen Signals, wobei der aktive Bereich (4) aus einer Vielzahl von Halbleiter-Unterbereichen (8, 9, 10) gebildet ist, die durch Teilabschnitte (11, 12) des Substrats (1) elektrisch voneinander isoliert sind und unabhängig mit jeweiligen zweiten Elektroden (13, 14, 15) verbunden sind, **dadurch gekennzeichnet, dass** die zweiten Elektroden (13, 14, 15) durch auswählbare Vorspannungen unabhängig gesteuert werden, die zum Erzeugen einer Lawinenmultiplikation von Ladungsträgern unter den entsprechenden Halbleiter-Unterbereichen (8, 9, 10) und eines resultierenden elektrischen Ausgangssignals, das das zu erfassende optische Signal anzeigt, fähig sind

2. Vorrichtung nach Anspruch 1, **dadurch gekennzeichnet, dass** sie einen weiteren Halbleiterbereich (3) des ersten Leitfähigkeitstyps mit hoher Dotierungsmitteldichte zur Verfügung stellt, der unter dem aktiven Bereich (4) vorgesehen ist.

3. Vorrichtung nach Anspruch 2, **dadurch gekennzeichnet, dass** die Breite des weiteren Halbleiterbereich (3) kleiner als die Breite des aktiven Bereichs (4) ist.

4. Vorrichtung nach Anspruch 1, **dadurch gekennzeichnet, dass** ein ringförmiger Halbleiterbereich (7) des zweiten Leitfähigkeitstyps mit einer niedrigeren Dotierungsmitteldichte als derjenigen der Halbleiter-Unterbereiche (8, 9, 10) des aktiven Bereichs (4) um den aktiven Bereich (4) vorgesehen ist.

5. Vorrichtung nach Anspruch 1, **dadurch gekennzeichnet, dass** die Halbleiter-Unterbereiche (8, 9, 10) des aktiven Bereichs (4) die Form von konzentrischen Ringen haben.

6. Vorrichtung nach Anspruch 1, **dadurch gekennzeichnet, dass** die Halbleiter-Unterbereiche (8, 9, 10) des aktiven Bereichs (4) die Form von Umfangssektoren haben.

7. Verfahren zur Erfassung eines optischen Signals, das Folgendes aufweist:
- den Einfall des optischen Signals auf einen aktiven Bereich (4) einer Halbleiter-Photodetektorvorrichtung, wobei der aktive Bereich (4) auf einer Oberfläche eines Halbleitersubstrats (1) eines ersten Leitfähigkeitstyps ausgebildet ist, das mit einer ersten Elektrode (2) verbunden ist und aus einer Vielzahl von Halbleiter-Unterbereichen (8, 9, 10) eines zweiten Leitfähigkeitstyps gebildet ist, die durch Teilabschnitte (11, 12) des Substrats (1) elektrisch voneinander isoliert sind und unabhängig mit jeweiligen Elektroden (13, 14, 15) verbunden sind,
- die elektronische Auswahl der Halbleiter-Unterbereiche (8, 9, 10) durch eine Verbindung der zweiten Elektroden (13, 14, 15) mit jeweiligen Vorspannungen, die zu einer Lawinenmultiplikation von Ladungsträgern unter den entsprechenden Halbleiter-Unterbereichen (8, 9, 10) fähig sind, und
- die Erfassung des durch die Lawinenmultiplikation der Ladungsträger erzeugten elektrischen Ausgangssignals.

8. Verfahren nach Anspruch 7, **dadurch gekennzeichnet, dass** einige der Halbleiter-Unterbereiche (8, 9, 10) des aktiven Bereichs (4), die freigegebene Bereiche genannt werden, mit einer Vorspannung verbunden werden, die niedriger als die Durchbruchspannung der Photodetektorvorrichtung ist, aber nahe genug zu ihr, um eine derartige Lawinenmultiplikation zu haben, um eine Stromverstärkung sicherzustellen, die signifikant größer als eins ist.

9. Verfahren nach Anspruch 7, **dadurch gekennzeichnet, dass** mehrere der Halbleiter-Unterbereiche (8, 9, 10) des aktiven Bereichs (4), die freigegebene Bereiche genannt werden, mit einer Vorspannung verbunden werden, die höher als die Durchbruchspannung der Photodetektorvorrichtung ist.

10. Verfahren nach Anspruch 8 oder 9, **dadurch gekennzeichnet, dass** die übrigen Halbleiter-Unterbereiche (8, 9, 10) des aktiven Bereichs (4), die verbotene Bereiche genannt werden, mit einer ausreichend niedrigen Spannung verbunden werden, um die Lawinenmultiplikation zu verhindern.

11. Verfahren nach Anspruch 7, 8, 9 oder 10, **dadurch gekennzeichnet, dass** das elektrische Ausgangssignal durch eine Ausgangselektrode, die eine der ersten und der zweiten Elektroden (2; 13, 14, 15) ist, unabhängig von der Auswahl der an die mehreren Halbleiter-Unterbereiche (8, 9, 10) angelegten Spannung zugeführt wird.

12. Verfahren nach Anspruch 11, **dadurch gekennzeichnet, dass** die Ausgangselektrode, die das elektrische Signal zuführt, die erste Elektrode (2) ist.

13. Verfahren nach Anspruch 11, **dadurch gekennzeichnet, dass** die Ausgangselektrode, die das elektrische Signal zuführt, eine der zweiten Elektroden (13, 14, 15) ist, die mit einem der Halbleiter-Unterbereiche (8, 9, 10) verbunden ist, der bei den Arbeitszuständen der Vorrichtung immer einen freigegebener Bereich ist.

## Revendications

1. Dispositif photodétecteur comprenant un substrat semiconducteur (1) ayant un premier type de conductivité connecté à une première électrode (2) et une région active (4) ayant un second type de conductivité formée sur une surface du substrat pour recevoir un signal optique à détecter, ladite région active (4) étant constituée d'une pluralité de sous-régions de semiconducteur (8, 9, 10) qui sont électriquement isolées les unes des autres par des parties (11, 12) du substrat (1) et sont connectées indépendamment à des deuxièmes électrodes respectives (13, 14, 15), **caractérisé en ce que** lesdites deuxièmes électrodes (13, 14, 15) sont commandées indépendamment par des tensions de polarisation sélectionnables, aptes à produire une multiplication par effet d'avalanche de porteurs de charge sous les sous-régions de semiconducteur correspondantes (8, 9, 10) et un signal de sortie électrique résultant représentant le signal optique à détecter.

2. Dispositif selon la revendication 1, **caractérisé en ce qu'**il fournit une région de semiconducteur supplémentaire (3) ayant le premier type de conductivité avec une forte densité d'atomes dopants, prévue sous ladite région active (4).

3. Dispositif selon la revendication 2, **caractérisé en ce que** la largeur de ladite région de semiconducteur supplémentaire (3) est inférieure à la largeur de ladite région active (4).

4. Dispositif selon la revendication 1, **caractérisé en ce qu'**une région de semiconducteur de forme annulaire (7) ayant le second type de conductivité avec une densité d'atomes dopants inférieure à celle desdites sous-régions de semiconducteur (8, 9, 10) de ladite région active (4) est prévue autour de ladite région active (4).

5. Dispositif selon la revendication 1, **caractérisé en ce que** lesdites sous-régions de semiconducteur (8, 9, 10) de ladite région active (4) ont la forme d'anneaux concentriques.

6. Dispositif selon la revendication 1, **caractérisé en ce que** lesdites sous-régions de semiconducteur (8, 9, 10) de ladite région active (4) ont la forme de secteurs de circonférence.

7. Procédé de détection d'un signal optique comprenant :
- l'arrivée dudit signal optique sur une région active (4) d'un dispositif photodétecteur à semiconducteur, ladite région active (4) étant formée sur une surface d'un substrat semiconducteur (1) ayant un premier type de conductivité connecté à une première électrode (2) et constituée d'une pluralité de sous-régions de semiconducteur (8, 9, 10) ayant un second type de conductivité électriquement isolées les unes des autres par des parties (11, 12) du substrat (1) et connectées indépendamment à des deuxièmes électrodes respectives (13, 14, 15),
- la sélection électronique desdites sous-régions de semiconducteur (8, 9, 10) par connexion desdites deuxièmes électrodes (13, 14, 15) à des tensions de polarisation respectives, aptes à produire une multiplication par effet d'avalanche de porteurs de charge sous les sous-régions de semiconducteur correspondantes (8, 9, 10), et
- la détection du signal de sortie électrique généré par la multiplication par effet d'avalanche des porteurs de charge.

8. Procédé selon la revendication 7, **caractérisé en ce que** certaines desdites sous-régions de semiconducteur (8, 9, 10) de ladite région active (4), nommées zones validées, sont connectées à une tension de polarisation inférieure à la tension de claquage dudit dispositif photodétecteur mais assez proche de celle-ci pour avoir une multiplication par effet d'avalanche des porteurs de charge apte à assurer un gain de courant significativement supérieur à l'unité.

9. Procédé selon la revendication 7, **caractérisé en ce que** plusieurs desdites sous-régions de semiconducteur (8, 9, 10) de ladite région active (4), nommées zones validées, sont connectées à une tension de polarisation supérieure à la tension de claquage dudit dispositif photodétecteur.

10. Procédé selon la revendication 8 ou 9, **caractérisé en ce que** les sous-régions de semiconducteur restantes (8, 9, 10) de ladite région active (4), nommées zones inhibées, sont connectées à une tension suffisamment basse pour empêcher l'effet d'avalanche.

11. Procédé selon les revendications 7, 8, 9, 10 **caractérisé en ce que** le signal de sortie électrique est fourni par une électrode de sortie qui est l'une desdites première et deuxième électrodes (2 ; 13, 14, 15) indépendamment du choix des tensions de polarisation appliquées aux diverses sous-régions de semiconducteur (8, 9, 10).

12. Procédé selon la revendication 11, **caractérisé en ce que** l'électrode de sortie qui fournit le signal électrique est la première électrode (2).

13. Procédé selon la revendication 11, **caractérisé en ce que** l'électrode de sortie qui fournit le signal électrique est l'une des deuxièmes électrodes (13, 14, 15), qui est connectée à l'une des sous-régions de semiconducteur (8, 9, 10) qui dans les conditions de service du dispositif est toujours une zone validée.
